# EUROPEAN PATENT APPLICATION

(11) **EP 4 832 318 A1**
(43) Date of publication of application: **28.10.2026**
(21) Application number: 24906888.3
(22) Date of filing: 15.10.2024
(51) Int. Cl.: H02K 41/03

(54) **DRIVING DEVICE, POSITIONING DEVICE, PROCESSING DEVICE, AND DEVICE MANUFACTURING METHOD**

(30) Priority: 21.12.2023 JP 2023215849
(71) Applicant: Sumitomo Heavy Industries, Ltd., Tokyo 141-6025 (JP)
(72) Inventor: YOSHIDA Tatsuya, Yokosuka-shi Kanagawa 237-8555 (JP); MUROI Naoto, Yokosuka-shi Kanagawa 237-8555 (JP)
(74) Representative: Louis Pöhlau Lohrentz
(86) International application number: PCT/JP2024/036637
(87) International publication number: WO 2025/134500

(57) **Abstract**

A stage device 1 includes a first drive shaft 100 that drives a stage 2 in an X-axis direction by magnetism, a second drive shaft 200 that drives the stage 2 and the first drive shaft 100 integrally in a Y-axis direction intersecting the X-axis direction by magnetism, a first gas levitation portion 10 that levitates an X slider 21 from an X guide 110 by gas, and a second gas levitation portion 20 that levitates a Y slider 150 from a Y guide 210 by gas. A first linear motor 120 that drives the X slider 21 along the first drive shaft 100 is constituted by the X slider 21 and the first drive shaft 100, and a second linear motor 220 that drives the Y slider 150 along the second drive shaft 200 is constituted by the Y slider 150 and the second drive shaft 200.

## Description

### Technical Field

The present disclosure relates to a driving device and the like.

### Background Art

PTL 1 discloses a driving device or an actuator used in a vacuum environment, which includes a slider driven along a predetermined movement direction by gas pressure in an air servo chamber, and a guide extending in the movement direction to guide the slider. An air bearing formed by compressed air supplied between an outer periphery of the slider and an inner periphery of the guide through an air pad allows the slider to levitate from the guide and move smoothly.

### Citation List

### Patent Literature

[PTL 1] Japanese Patent No. 6893170

### Summary of Invention

### Technical Problem

In a gas pressure actuator as in PTL 1, there is a problem in that it is difficult to increase responsiveness or quick responsiveness in a case of driving a slider due to a physical constraint based on a principle of converting a gas pressure in an air servo chamber into a thrust force of the slider.

The present disclosure has been made in view of such circumstances, and an object of the present disclosure is to provide a driving device or the like capable of achieving both smoothness and responsiveness in a case of driving a driven body.

### Solution to Problem

According to an aspect of the present disclosure, there is provided a driving device including a first drive shaft that drives a driven body in a first direction by magnetism, a second drive shaft that drives the driven body and the first drive shaft integrally in a second direction intersecting the first direction by magnetism, a first gas levitation portion that levitates the driven body from the first drive shaft by gas, and a second gas levitation portion that levitates the first drive shaft from the second drive shaft by gas.

According to the present aspect, high responsiveness during driving can be implemented by the first drive shaft and the second drive shaft that drive the driven body and the first drive shaft by magnetism, and high smoothness during driving can be implemented by the first gas levitation portion and the second gas levitation portion that levitate the driven body and the first drive shaft by gas.

Another aspect of the present disclosure is a positioning device. This device positions the driven body by the above-described driving device.

Still another aspect of the present disclosure is a processing device. The device performs predetermined processing on the driven body positioned by the positioning device.

Yet another aspect of the present disclosure is a device manufacturing method. In the method, a device is manufactured through processing performed by the processing device.

Any combination of the above components and representations thereof converted into a method, a device, a system, a recording medium, a computer program, and the like are also included in the present disclosure.

### Advantageous Effects of Invention

According to the present disclosure, both smoothness and responsiveness during driving of the driven body can be achieved.

### Brief Description of Drawings

FIG. 1 is a perspective view schematically illustrating a stage device according to a first embodiment.
FIG. 2 is a perspective view schematically illustrating details of a first linear motor.
FIG. 3 is a cross-sectional view schematically illustrating a first gas levitation portion that smooths driving of an X slider in an X-axis direction by the first drive shaft with a levitation gas.
FIG. 4 is a cross-sectional view schematically illustrating a second gas levitation portion that smooths driving of a Y slider in a Y-axis direction by the second drive shaft with a levitation gas.
FIG. 5 is a perspective view schematically illustrating a stage device according to a second embodiment.
FIG. 6 schematically illustrates the first linear motor viewed in the Y-axis direction.
FIG. 7 is a partial enlarged view of a first magnet portion.

### Description of Embodiments

Hereinafter, a form for embodying the present disclosure (hereinafter, also referred to as an embodiment) will be described in detail with reference to the accompanying drawings. In the description and/or the drawings, the same reference signs are assigned to the same or equivalent components, members, processes, and the like, and repeated descriptions thereof are omitted. The scale and shape of each unit illustrated in the drawings are set for convenience to simplify the description, and are not to be construed as limiting unless otherwise specifically stated. The embodiment is illustrative and does not limit the scope of the present disclosure in any way. All the features and combinations thereof presented in the embodiment are not necessarily essential to the present disclosure. For convenience, the embodiment is presented by decomposing the embodiment into components for each function and/or for each function group implementing the embodiment. However, one component in the embodiment may actually be implemented by a combination of a plurality of separate components, and a plurality of components in the embodiment may actually be implemented by one component as an integral body. In addition, a plurality of embodiments or modifications may be disclosed in parallel. However, any components of each embodiment and/or each modification may be combined in any manner as long as each other's functions are not impaired.

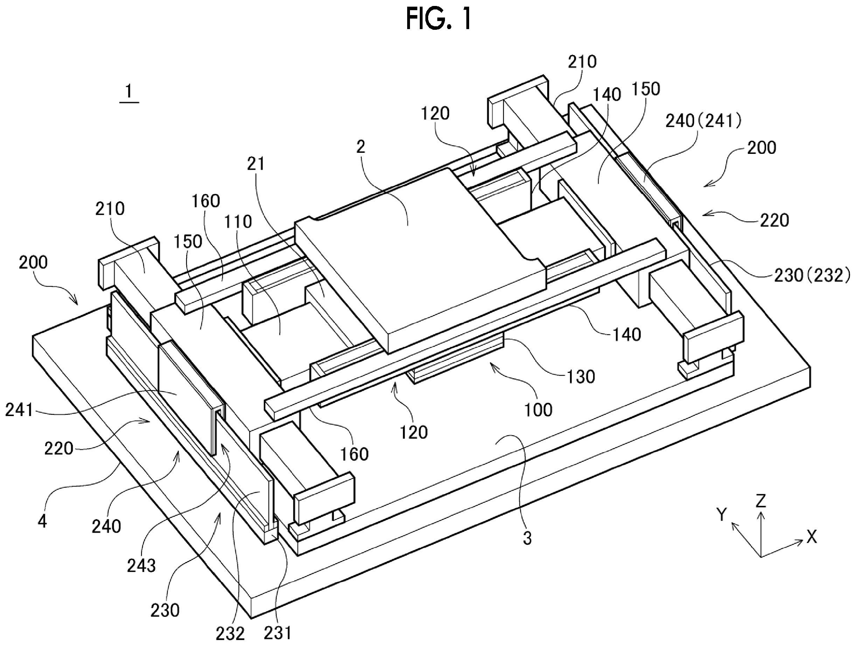

FIG. 1 is a perspective view schematically illustrating a stage device 1 as a driving device or a positioning device according to a first embodiment of the present disclosure. In the present embodiment, for convenience, a three-dimensional coordinate system or an XYZ coordinate system formed by an X-axis, a Y-axis, and a Z-axis that are orthogonal to each other is set. An X-axis direction is a first direction in which a first drive shaft 100, which will be described later, drives a stage 2 or a table as a driven body. A Y-axis direction is a second direction in which a second drive shaft 200, which will be described later, integrally drives the stage 2 and the first drive shaft 100. A Z-axis direction is a third direction as a normal direction to a drive plane or an XY plane formed by the X-axis and the Y-axis. The XY plane is preferably a horizontal plane, and the Z-axis direction in this case is a vertical direction. The X-axis, the Y-axis, and the Z-axis do not need to be orthogonal to each other, and may at least intersect with each other. In other words, the X-axis direction, the Y-axis direction, and the Z-axis direction may be different from each other.

The stage device 1 includes the first drive shaft 100 that drives the stage 2 in the X-axis direction by magnetism, and the second drive shaft 200 that integrally drives the stage 2 and the first drive shaft 100 in the Y-axis direction by magnetism. In an example of the present embodiment, a pair of (that is, two) substantially identical second drive shafts 200 are provided at both end portions of the first drive shaft 100 extending in the X-axis direction. Hereinafter, unless otherwise specified, the two second drive shafts 200 will be collectively described without being distinguished.

One first drive shaft 100 and two second drive shafts 200 form a substantially H shape when viewed in the Z-axis direction or when viewed from above. The two second drive shafts 200 are fixedly installed on a surface of a surface plate 3, the surface being in an XY plane or a horizontal plane. The one first drive shaft 100 is in a non-contact state spaced apart from the surface of the surface plate 3 in the Z-axis direction so as to be movable in the Y-axis direction on the surface plate 3 through the two second drive shafts 200. The surface plate 3 is further fixedly installed on a surface of a base 4, the surface being in an XY plane or a horizontal plane.

Any object (not illustrated) is placed on the surface of the stage 2 constituting the driven body. Here, the "surface" in the present embodiment represents a surface on the +Z side (an upper surface in FIG. 1), and the "rear surface" in the present embodiment represents a surface on the -Z side (a lower surface in FIG. 1). Any workpiece such as a semiconductor wafer may be placed on the surface of the stage 2. In this case, the stage device 1 constitutes a positioning device that positions the workpiece placed on the stage 2 as the driven body, and further constitutes a part of a processing device that performs any processing on the workpiece positioned by the positioning device. Examples of the processing device include a semiconductor manufacturing device such as an exposure device, an ion implanter, a heat treatment device, an ashing device, a sputtering device, a dicing device, an inspection device, and a cleaning device, and a flat panel display (FPD) manufacturing device.

The first drive shaft 100 that drives the stage 2 as the driven body in the X-axis direction includes an X guide 110 extending in the X-axis direction. The X guide 110 constitutes a main body of the first drive shaft 100. An X slider 21 movable or slidable in the X-axis direction while being guided by the X guide 110 is provided on the X guide 110. A surface (surface on the +Z side) of the X slider 21 is connected to a rear surface (surface on the -Z side) of the stage 2 and integrally constitutes the driven body. Therefore, the stage 2 is movable integrally with the X slider 21 in the X-axis direction while being guided by the X guide 110. As will be described later, since a levitation gas such as compressed air is supplied between an inner peripheral surface of the X slider 21 constituting the driven body and an outer peripheral surface of the X guide 110 constituting the first drive shaft 100, the X slider 21 can be levitated from the X guide 110 and can smoothly move in a substantially non-contact manner.

In order to drive the driven body constituted by the stage 2 and the X slider 21 along the X-axis direction, a first linear motor 120 is constituted between the driven body and the first drive shaft 100. In the present embodiment, a pair of (that is, two) substantially identical first linear motors 120 are provided on both sides of the X slider 21 as the driven body (and the X guide 110 as a main body of the first drive shaft 100) in the Y-axis direction. In addition, each first linear motor 120 is provided on the X slider 21 on a rear surface side of the driven body constituted by the stage 2 and the X slider 21. In this way, by providing each first linear motor 120 on the X slider 21 on the rear surface side spaced apart from the stage 2 on the surface side, an adverse effect that magnetism leaked from each first linear motor 120 may have on processing of a semiconductor wafer or the like on the stage 2 (for example, irradiation with an electron beam susceptible to an influence of magnetism) can be reduced.

In general, a linear motor includes a coil portion constituted by a plurality of coils through which a current flows from the outside to generate a magnetic field, and a magnet portion constituted by a plurality of magnets that interact with the magnetic field generated by the coil portion. The first linear motor 120 according to the present embodiment also includes a first coil portion 130 as a coil portion and a first magnet portion 140 as a magnet portion. In order to configure the first linear motor 120 that drives the X slider 21 (and the stage 2) as the driven body along the X-axis direction, one of the first coil portion 130 and the first magnet portion 140 may be provided on the X slider 21, and the other may be provided on the first drive shaft 100.

In the first linear motor 120, it is preferable that the first coil portion 130 is provided on the X slider 21 and the first magnet portion 140 is provided on the first drive shaft 100. As illustrated, the first magnet portion 140 may be attached to a beam portion 160 having a columnar shape bridged between a pair of Y sliders 150 (described later) constituting a part of the first drive shaft 100. Although their disposition is optional, for example, when viewed in the Z-axis direction, the X slider 21, the first magnet portion 140 (or the first coil portion 130), and the beam portion 160 are disposed in this order from the central X slider 21 toward the outer side in the Y-axis direction. Further, the first magnet portion 140 and the beam portion 160 each elongated in the X-axis direction are disposed substantially in parallel on both sides in the Y-axis direction of the X guide 110 similarly elongated in the X-axis direction. However, the first magnet portion 140 and the beam portion 160 are not in contact with the X guide 110, and the X slider 21 is movable in a gap therebetween.

The first coil portion 130 is driven integrally with the X slider 21 in the X-axis direction by a magnetic interaction with the first magnet portion 140. Since the first coil portion 130 moves in this way, the first linear motor 120 is a so-called moving coil type linear motor. In this case, since the first magnet portion 140 is stationary in the X-axis direction (moves in the Y-axis direction by the second drive shaft 200), there is an advantage that a fluctuation in magnetism leaking outside the first linear motor 120 is small. This is particularly preferable when processing of a semiconductor wafer or the like on the stage 2 is susceptible to an influence of magnetism.

In the moving coil type first linear motor 120, the length of the first coil portion 130 in the X-axis direction is shorter than the length of the first magnet portion 140 in the X-axis direction. For example, it is preferable that the length of the first coil portion 130 in the X-axis direction is equal to or less than the length of the X slider 21 and/or the stage 2 in the X-axis direction. In addition, it is preferable that the length of the first magnet portion 140 in the X-axis direction is a length that can cover the movable range of the X slider 21 in the X-axis direction. As will be described later, the first coil portion 130 having a relatively short length is movable in the X-axis direction integrally with the X slider 21 and the stage 2 as the driven body within an installation range of the first magnet portion 140 having a relatively long length.

On the other hand, when processing of a semiconductor wafer or the like on the stage 2 is less susceptible to an influence of magnetism, the first linear motor 120 may be configured as a so-called moving magnet type. Specifically, the first coil portion 130 is provided on the first drive shaft 100 (for example, beam portion 160), and the first magnet portion 140 is provided on the X slider 21 (not illustrated). In this case, since the first coil portion 130 that generates heat due to a current flowing therethrough is isolated from the driven body integrated with the stage 2 or from the X slider 21, heat transfer to the stage 2 and/or the workpiece such as a semiconductor wafer can be effectively suppressed. This is particularly preferable when the workpiece such as a semiconductor wafer is susceptible to an influence of heat.

In the moving magnet type first linear motor 120, the length of the first coil portion 130 in the X-axis direction is longer than the length of the first magnet portion 140 in the X-axis direction. For example, it is preferable that the length of the first coil portion 130 in the X-axis direction is a length that can cover the movable range of the X slider 21 in the X-axis direction. In addition, it is preferable that the length of the first magnet portion 140 in the X-axis direction is equal to or less than the length of the X slider 21 and/or the stage 2 in the X-axis direction. The first magnet portion 140 having a relatively short length is movable in the X-axis direction integrally with the X slider 21 and the stage 2 as the driven body within the installation range of the first coil portion 130 having a relatively long length.

By providing the pair of first linear motors 120 as described above on both sides of the X slider 21 and the stage 2 as the driven body in the Y-axis direction, the driven body can be stably driven in the X-axis direction while effectively suppressing undesirable rotation such as yawing (rotation around the Z-axis).

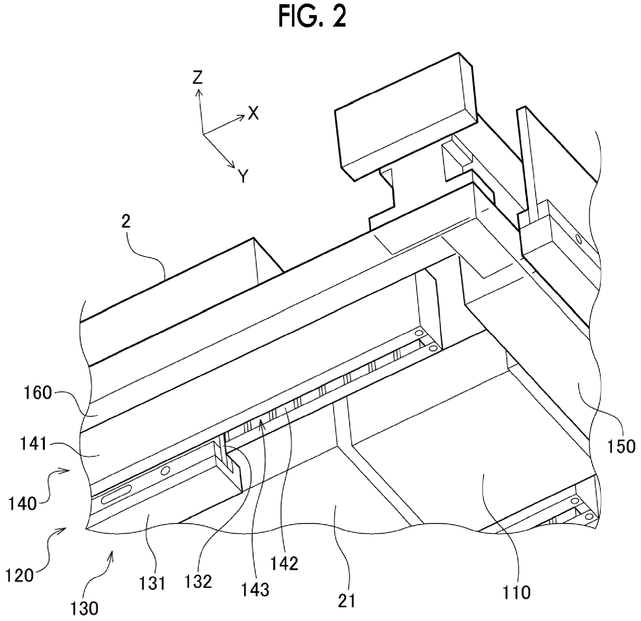

FIG. 2 is a perspective view schematically illustrating details of the first linear motor 120. This figure illustrates the first linear motor 120 in FIG. 1 viewed from the rear surface side (-Z side).

The first coil portion 130 includes a holder 131, and a coil 132 that is held by the holder 131. Although not illustrated in detail, the coil 132 is, for example, a general three-phase coil. Specifically, a U-phase coil, a V-phase coil, and a W-phase coil (not illustrated) are periodically disposed along the X-axis direction, which is a driving direction. Currents (for example, a U-phase current, a V-phase current, and a W-phase current) flowing through the coil 132 of each phase may be supplied via the holder 131. The coil 132 is provided so as to protrude from the holder 131 on the rear surface side toward the surface side (+Z side). Such a coil 132 or a coil group is preferably formed in a flat plate shape having the Y-axis direction as a normal direction as a whole. The holder 131 is fixedly attached to a side surface of the X slider 21 as the driven body, preferably on the rear surface side. Therefore, the first coil portion 130 is movable integrally with the X slider 21 in the X-axis direction.

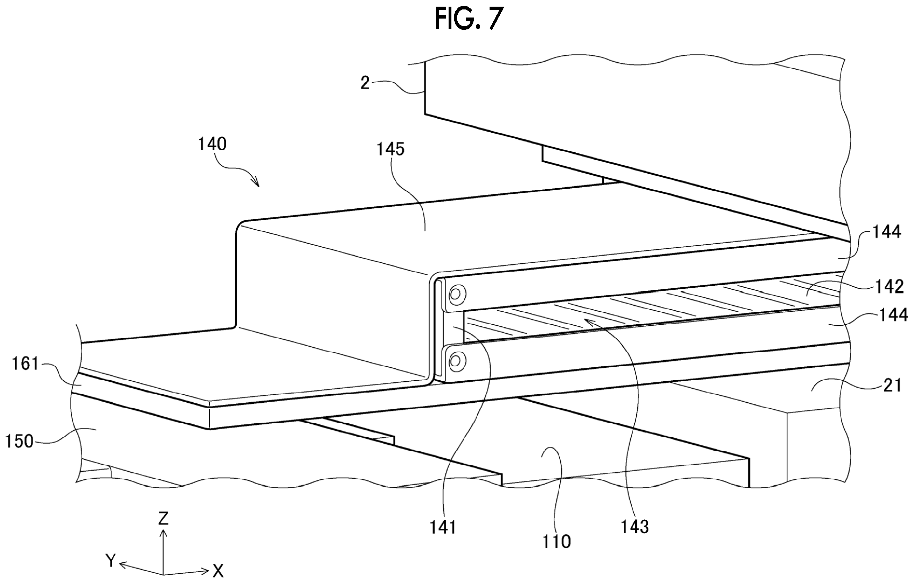

The first magnet portion 140 includes a casing 141 having a substantially rectangular parallelepiped shape and magnets 142 arranged on an inner peripheral surface of the casing 141. The casing 141 is made of, for example, a magnetic shielding material or a soft magnetic material such as carbon steel or permalloy. An elongated opening 143 extending in the X-axis direction over substantially the entire length thereof is formed on a rear surface of the casing 141 (a surface of the casing 141 is closed by a magnetic shielding material or the like). Although explicit illustration is omitted, a first magnetic shielding portion 144, which will be described later, with reference to FIG. 7 and the like may be provided on an edge portion of the opening 143 or a side surface of the casing 141. The above-described coil 132 having a flat plate shape is inserted into a space having a substantially rectangular parallelepiped shape in the casing 141 formed by this opening 143. In addition, the magnets 142 such as permanent magnets whose magnetic poles are periodically changed are arranged along the X-axis direction on the inner peripheral surface of the casing 141 that is a side wall surface of the space.

In this manner, in the space having a substantially rectangular parallelepiped shape in the casing 141, the coil 132 or a coil group in the first coil portion 130 and the magnets 142 or a magnet group in the first magnet portion 140 face each other in the Y-axis direction. Then, the coil 132, functioning as an electromagnet when a three-phase alternating current or the like flows therethrough, magnetically interacts with the magnets 142, so that a thrust force for driving the coil 132 as a movable portion in the X-axis direction is generated. The coil 132 having a flat plate shape is driven along the X-axis direction in the space having a substantially rectangular parallelepiped shape in the casing 141. The X slider 21 and the stage 2 as the driven body to which the coil 132 or the first coil portion 130 is fixed are also driven integrally with the first coil portion 130 in the X-axis direction while being guided by the X guide 110.

As described above, in the example of FIG. 2, the coil 132 through which a current flows is provided so as to protrude from the holder 131 toward the surface side (+Z side), and the first magnet portion 140 or the magnets 142 that interact with the magnetic field generated by the coil 132 are provided so as to cover the coil 132 from the surface side. In such a first linear motor 120, since the opening 143 through which magnetism from the coil 132 and/or the magnets 142 leaks is provided on the rear surface side far from the stage 2, an adverse effect that the magnetism may have on processing of a semiconductor wafer or the like on the stage 2 can be reduced.

In FIG. 1, the second drive shaft 200 that integrally drives the stage 2 and the X slider 21 as the driven body and the first drive shaft 100 in the Y-axis direction includes a Y guide 210 extending in the Y-axis direction. The Y guide 210 constitutes a main body of the second drive shaft 200. A Y slider 150 movable or slidable in the Y-axis direction while being guided by the Y guide 210 is provided on the Y guide 210.

The Y slider 150 is a part of the above-described first drive shaft 100. Specifically, a pair of (that is, two) substantially identical Y sliders 150 are integrally provided at both end portions of the X guide 110 as a main body of the first drive shaft 100 in the X-axis direction. When a pair of second drive shafts 200 drive the pair of Y sliders 150 in the Y-axis direction, the entire first drive shaft 100 integrally configured with the Y sliders 150, and the stage 2 and the X slider 21 as the driven body are also integrally driven in the Y-axis direction. In this manner, a drive target of the second drive shaft 200 includes the entire first drive shaft 100 having the Y sliders 150 as a part thereof, and the driven body constituted by the stage 2 and the X slider 21.

The stage 2 as the driven body is movable integrally with the Y slider 150 in the Y-axis direction while being guided by the Y guide 210. As will be described later, since a levitation gas such as compressed air is supplied between an inner peripheral surface of the Y slider 150 constituting the first drive shaft 100 and an outer peripheral surface of the Y guide 210 constituting the second drive shaft 200, the Y slider 150 can be levitated from the Y guide 210 and can smoothly move in a substantially non-contact manner.

In order to drive the drive target including the stage 2 and the Y slider 150 along the Y-axis direction, a second linear motor 220 is constituted between the drive target and the second drive shaft 200. In the present embodiment, a pair of (that is, two) substantially identical second linear motors 220 are provided on the outer side of each Y guide 210 and each Y slider 150 in the X-axis direction.

The second linear motor 220 includes a second coil portion 230 as a coil portion and a second magnet portion 240 as a magnet portion. In order to configure the second linear motor 220 that drives the Y slider 150 as the drive target along the Y-axis direction, one of the second coil portion 230 and the second magnet portion 240 may be provided on the Y slider 150, and the other may be provided on the second drive shaft 200.

In the second linear motor 220, it is preferable that the second coil portion 230 is provided adjacently to the second drive shaft 200 and the second magnet portion 240 is provided on the Y slider 150. As illustrated, the second coil portion 230 may be fixedly installed on the base 4 adjacent to the second drive shaft 200. Since the base 4, the surface plate 3, and the second drive shaft 200 are fixed to each other, even when the second coil portion 230 is provided on any of the base 4, the surface plate 3, and the second drive shaft 200, the second coil portion 230 should be interpreted as being substantially provided on the second drive shaft 200. The second coil portion 230 (in particular, a coil 232 to be described later) is not in contact with the Y guide 210 and the Y slider 150, and the second magnet portion 240 (in particular, a casing 241 to be described later) is movable in the Y-axis direction in a gap therebetween. In this manner, the second coil portion 230 is provided at a position spaced apart from the Y guide 210 as a main body of the second drive shaft 200 in the X-axis direction.

The second coil portion 230 includes a holder 231 installed on the base 4, and the coil 232 that is held by the holder 231. Although detailed illustration is omitted, the coil 232 is, for example, a general three-phase coil. Specifically, a U-phase coil, a V-phase coil, and a W-phase coil (not illustrated) are periodically disposed along the Y-axis direction, which is a driving direction. Currents (for example, a U-phase current, a V-phase current, and a W-phase current) flowing through the coil 232 of each phase may be supplied via the holder 231. The coil 232 is provided so as to protrude from the holder 231 on the rear surface side (-Z side) toward the surface side (+Z side). Such a coil 232 or a coil group is preferably formed in a flat plate shape having the X-axis direction as a normal direction as a whole. In addition, when viewed in the Z-axis direction, the entire second coil portion 230 and/or the coil 232 extends along the Y-axis direction substantially parallel to the Y guide 210.

The second magnet portion 240 includes a casing 241 having a substantially rectangular parallelepiped shape, and magnets (not illustrated) arranged on an inner peripheral surface of the casing 241. The casing 241 is fixedly attached to a side surface of the Y slider 150 as the drive target having the X-axis direction as a normal direction. Therefore, the second magnet portion 240 is movable integrally with the Y slider 150 in the Y-axis direction.

The casing 241 is made of, for example, a magnetic shielding material or a soft magnetic material such as carbon steel or permalloy. A space 243 having a substantially rectangular parallelepiped shape penetrating in the Y-axis direction and opening at the rear surface is formed inside the casing 241. The casing 241 has an inverted U-shape when viewed in the Y-axis direction. The above-described flat plate-shaped coil 232 is inserted into the space 243 having a substantially rectangular parallelepiped shape in the casing 241. Further, magnets (not illustrated) such as permanent magnets having magnetic poles periodically changed are arranged on the inner peripheral surface of the casing 241 that is a side wall surface of the space 243 along the Y-axis direction.

In this manner, in the space 243 having a substantially rectangular parallelepiped shape inside the casing 241, the coil 232 or a coil group in the second coil portion 230 and the magnets (not illustrated) or a magnet group in the second magnet portion 240 face each other in the X-axis direction. Then, the coil 232, functioning as an electromagnet when a three-phase alternating current or the like flows therethrough, magnetically interacts with the magnets (not illustrated), so that a thrust force for driving the second magnet portion 240 as a movable portion in the Y-axis direction is generated. The casing 241 having an inverted U-shape when viewed in the Y-axis direction is driven in the Y-axis direction along the flat plate-shaped coil 232 in a state in which the flat plate-shaped coil 232 is sandwiched from above (a state in which the coil 232 is included in the space 243 in the casing 241). The Y slider 150 as the drive target to which the casing 241 of the second magnet portion 240 is fixed is also integrally driven in the Y-axis direction with the second magnet portion 240 while being guided by the Y guide 210.

As described above, in the example of FIG. 1, the coil 232 through which a current flows is provided so as to protrude from the holder 231 toward the surface side (+Z side), and the second magnet portion 240 that interacts with the magnetic field generated by the coil 232 is provided so as to cover the coil 232 from the surface side. In such a second linear motor 220, since the space 243 from which magnetism from the coil 232 and/or the second magnet portion 240 leaks is provided on the rear surface side far from the stage 2, an adverse effect that the magnetism may exert on processing of a semiconductor wafer or the like on the stage 2 can be reduced.

The second linear motor 220 as described above, in which the second magnet portion 240 moves, is a so-called moving magnet type linear motor. In this case, since the second coil portion 230 that generates heat due to a current flowing therethrough is isolated from the drive target or the Y slider 150 integral with the stage 2 (further, in the illustrated example, the second coil portion 230 is also thermally isolated from the second drive shaft 200 via the base 4 and the surface plate 3), heat transfer to the stage 2 and/or the workpiece such as a semiconductor wafer can be effectively suppressed. This is particularly preferable when the workpiece such as a semiconductor wafer is susceptible to an influence of heat, or when the stage 2 itself is easily deformed by heat.

In such a moving magnet type second linear motor 220, the length of the second coil portion 230 in the Y-axis direction is longer than the length of the second magnet portion 240 in the Y-axis direction. For example, it is preferable that the length of the second coil portion 230 in the Y-axis direction is a length that can cover the movable range of the Y slider 150 in the Y-axis direction. In addition, it is preferable that the length of the second magnet portion 240 in the Y-axis direction is equal to or shorter than the length of the Y slider 150 and/or the stage 2 in the Y-axis direction. The second magnet portion 240 having a relatively short length is movable integrally with the Y slider 150 in the Y-axis direction as the drive target within the installation range of the second coil portion 230 having a relatively long length.

In the illustrated example, in order to reduce an influence of magnetism on the stage 2 or the like, the first linear motor 120 is preferably a moving coil type, and in order to reduce an influence of heat on the stage 2 or the like, the second linear motor 220 is preferably a moving magnet type. In this manner, in the stage device 1 according to the present embodiment, the first linear motor 120 and the second linear motor 220 are preferably of different types.

On the other hand, in order to further reduce an influence of magnetism on the stage 2 or the like, the second linear motor 220 may be configured as a moving coil type. Specifically, the second coil portion 230 is provided on the Y slider 150, and the second magnet portion 240 is provided on the second drive shaft 200 (for example, the base 4) (not illustrated). In this case, since the second magnet portion 240 is stationary, there is an advantage that a fluctuation in magnetism leaking outside the second linear motor 220 is small. This is particularly preferable when processing of a semiconductor wafer or the like on the stage 2 is susceptible to an influence of magnetism.

In such a moving coil type second linear motor 220, the length of the second coil portion 230 in the Y-axis direction is shorter than the length of the second magnet portion 240 in the Y-axis direction. For example, it is preferable that the length of the second coil portion 230 in the Y-axis direction is equal to or shorter than the length of the Y slider 150 and/or the stage 2 in the Y-axis direction. In addition, it is preferable that the length of the second magnet portion 240 in the Y-axis direction is a length that can cover the movable range of the Y slider 150 in the Y-axis direction. The second coil portion 230 having a relatively short length is movable integrally with the Y slider 150 in the Y-axis direction as the drive target within the installation range of the second magnet portion 240 having a relatively long length.

By providing the pair of second linear motors 220 as described above on both sides of the first drive shaft 100 as the drive target in the X-axis direction, the drive target can be stably driven in the Y-axis direction while effectively suppressing undesirable rotation such as yawing (rotation around the Z-axis).

Next, a gas levitation portion for smoothing driving in the X-axis direction by the first drive shaft 100 and driving in the Y-axis direction by the second drive shaft 200 will be described.

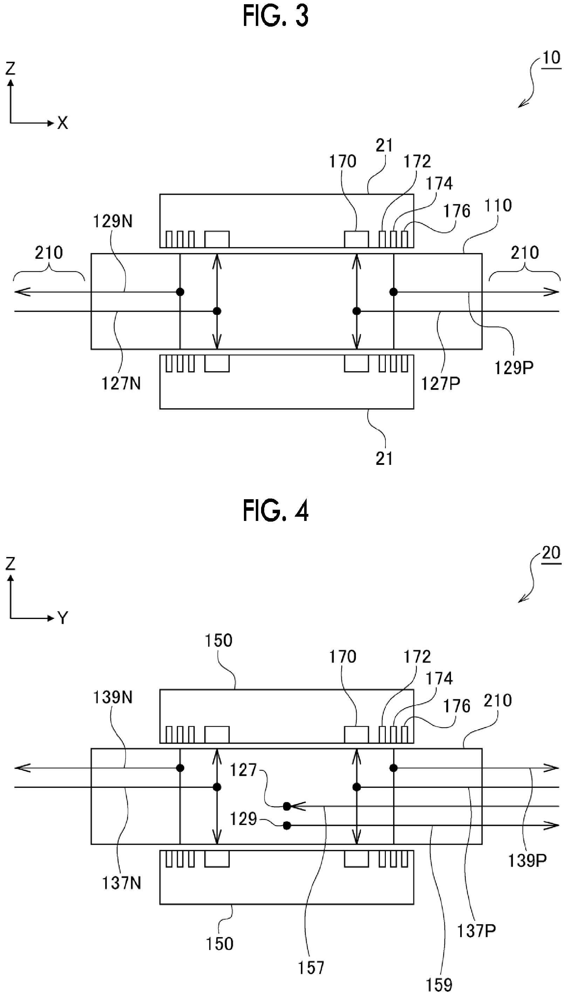

FIG. 3 is a cross-sectional view schematically illustrating a first gas levitation portion 10 for smoothing driving of the X slider 21 in the X-axis direction by the first drive shaft 100 by a levitation gas. Specifically, a ZX cross-section at the center of the X guide 110, which is a main body of the first drive shaft 100, in the Y-axis direction is schematically illustrated. The first gas levitation portion 10 levitates the X slider 21 as the driven body from the X guide 110, which is a main body of the first drive shaft 100, by gas.

An air pad 170 as a static pressure bearing is formed between the outer peripheral surface of the X guide 110 and an inner peripheral surface of the X slider 21 such that the X slider 21 can smoothly move in the X-axis direction along the X guide 110. The air pad 170 is formed in such a manner that a first levitation gas such as compressed air supplied through a first levitation pipe 127 provided inside the X guide 110, which is a main body of the first drive shaft 100, is always supplied between the outer peripheral surface of the X guide 110 and the inner peripheral surface of the X slider 21. The X slider 21 levitated from the X guide 110 by the air pad 170 can smoothly move in a substantially non-contact manner with the X guide 110.

A plurality of air pads 170 are preferably provided at symmetrical positions sandwiching the center of the X slider 21 in the X-axis direction and/or the Y-axis direction from both positive and negative sides in the X-axis direction and/or the Y-axis direction. In addition, the plurality of air pads 170 are preferably provided at symmetrical positions sandwiching the X guide 110 from both positive and negative sides in the Z-axis direction. By such a symmetrical disposition of the plurality of air pads 170 in the X-axis direction, the Y-axis direction, the Z-axis direction, and the like, undesirable rotation of the X slider 21 is effectively suppressed.

The first levitation pipe 127 includes a positive-side first levitation pipe 127P and a negative-side first levitation pipe 127N. In the example of the present embodiment, the positive-side first levitation pipe 127P and the negative-side first levitation pipe 127N provided inside the X guide 110 communicate with a levitation gas relay pipe provided inside the Y guide 210, as will be described later. However, the positive-side first levitation pipe 127P and the negative-side first levitation pipe 127N may communicate with a levitation gas supply pipe or a tube (not illustrated) that is directly attached to the outside of the X guide 110 and supplies a levitation gas from the outside. Alternatively, pipes that supply a levitation gas to the air pads 170, such as the positive-side first levitation pipe 127P and the negative-side first levitation pipe 127N, may be provided not inside the X guide 110 but inside the X slider 21. In this case, a levitation gas supply pipe or a tube (not illustrated) that is directly attached to the outside of the X slider 21 and supplies a levitation gas from the outside may be provided.

For example, a positive-side first levitation gas from a pump (not illustrated) is supplied to the air pad 170 on the positive side in the X-axis direction via a positive-side levitation gas relay pipe inside the positive-side Y guide 210 and the positive-side first levitation pipe 127P inside the X guide 110. Similarly, a negative-side first levitation gas from a pump (not illustrated) is supplied to the air pad 170 on the negative side in the X-axis direction via a negative-side levitation gas relay pipe inside the negative-side Y guide 210 and the negative-side first levitation pipe 127N inside the X guide 110.

The first levitation gas may be supplied from the levitation gas relay pipe and the first levitation pipe 127 on one of the positive side and the negative side to the air pads 170 on both the positive side and the negative side. For example, the first levitation gas from a pump (not illustrated) may be supplied to the air pads 170 on both the positive side and the negative side via the positive-side levitation gas relay pipe inside the positive-side Y guide 210 and the positive-side first levitation pipe 127P inside the X guide 110. In this case, all or a portion of the negative-side levitation gas relay pipe inside the negative-side Y guide 210 and at least a portion of the negative-side first levitation pipe 127N may not be provided on the negative side to which the first levitation gas is not supplied.

When the stage device 1 is used in a vacuum chamber, it is necessary to prevent the first levitation gas such as compressed air supplied to the air pads 170 from leaking into the vacuum chamber. Therefore, in the present embodiment, exhaust grooves 172, 174, and 176 for exhausting the first levitation gas in the air pads 170 to the outside of the vacuum chamber are provided on the inner peripheral surface of the X slider 21. As illustrated, the exhaust grooves 172, 174, and 176 are provided at positions sandwiching the air pads 170 from both positive and negative sides in the X-axis direction and/or the Y-axis direction. In other words, the exhaust grooves 172, 174, and 176 are provided on the inner peripheral surface of the X slider 21 at positions on the outer side of the air pads 170.

The exhaust grooves 172, 174, and 176 are provided such that a pressure sequentially decreases, that is, a degree of vacuum sequentially increases from the inner side or the center toward the outside. For example, the exhaust groove 172 is set to an atmospheric pressure, the exhaust groove 174 is set to a low vacuum, and the exhaust groove 176 is set to a medium vacuum. The exhaust grooves 172, 174, and 176 having different pressures or degrees of vacuum in this manner are implemented by a plurality of first exhaust pipes 129 (only one is illustrated in FIG. 3 for convenience) provided inside the X guide 110, which is a main body of the first drive shaft 100. Specifically, the first exhaust pipe 129 communicating with the atmosphere or air at the atmospheric pressure is opened at a position facing the exhaust groove 172. In this manner, the exhaust groove 172 has the atmospheric pressure. The first exhaust pipe 129 connected to a low vacuum pump (not illustrated) or the like is opened at a position facing the exhaust groove 174. In this manner, the exhaust groove 174 has a low vacuum. The first exhaust pipe 129 connected to a medium vacuum pump (not illustrated) or the like is opened at a position facing the exhaust groove 176. In this manner, the exhaust groove 176 has a medium vacuum.

By the plurality of exhaust grooves 172, 174, and 176 and the plurality of first exhaust pipes 129 as described above, the first levitation gas in the air pads 170 is sequentially exhausted to the outside of the vacuum chamber through the atmospheric pressure (the exhaust groove 172), the low vacuum (the exhaust groove 174), and the medium vacuum (the exhaust groove 176). Therefore, the leakage of the first levitation gas in the air pads 170 into the vacuum chamber is effectively prevented.

As described above, the stage device 1 according to the present embodiment can be used in a vacuum environment such as in the vacuum chamber. Here, the vacuum represents a state of a space filled with a gas having a pressure lower than a normal atmospheric pressure. The vacuum is classified into a low vacuum (100 kPa to 100 Pa), a medium vacuum (100 Pa to 0.1 Pa), a high vacuum (0.1 Pa to 10⁻⁵ Pa), an ultra-high vacuum (10⁻⁵ Pa or lower), and the like depending on a pressure region. The stage device 1 according to the present embodiment may be used in a vacuum environment of any of the above categories, or may be used in a non-vacuum environment. The stage device 1 according to the present embodiment is particularly suitable for use in a vacuum environment having a low pressure where high cleanliness is required.

The first exhaust pipe 129 includes a positive-side first exhaust pipe 129P and a negative-side first exhaust pipe 129N. In the example of the present embodiment, the positive-side first exhaust pipe 129P and the negative-side first exhaust pipe 129N provided inside the X guide 110 communicate with exhaust relay pipes provided inside the Y guide 210, as will be described later. In this case, the first exhaust pipe 129 exhausts the first levitation gas to the Y guide 210, which is a main body of the second drive shaft 200 and in which the exhaust relay pipes are provided. The exhaust relay pipes in the Y guide 210 are respectively connected to, for example, the atmosphere, the low vacuum pump, and the medium vacuum pump in order to implement the atmospheric pressure (the exhaust groove 172), the low vacuum (the exhaust groove 174), and the medium vacuum (the exhaust groove 176) described above. However, the positive-side first exhaust pipe 129P and the negative-side first exhaust pipe 129N may communicate with an exhaust pipe or a tube (not illustrated) that is directly attached to the outside of the X guide 110 and supplies the atmospheric pressure, the low vacuum, the medium vacuum, and the like from the outside. Alternatively, pipes that supply the atmospheric pressure, the low vacuum, the medium vacuum, and the like, such as the positive-side first exhaust pipe 129P and the negative-side first exhaust pipe 129N, may be provided not inside the X guide 110 but inside the X slider 21. In this case, an exhaust pipe or a tube (not illustrated) that is directly attached to the outside of the X slider 21 and supplies the atmospheric pressure, the low vacuum, the medium vacuum, and the like from the outside may be provided.

The exhaust from the exhaust groove 172 is exhausted to the atmosphere via the first exhaust pipe 129 (129P and/or 129N) for the atmospheric pressure inside the X guide 110 and the exhaust relay pipe for the atmospheric pressure inside the Y guide 210. The exhaust from the exhaust groove 174 is exhausted via the first exhaust pipe 129 (129P and/or 129N) for the low vacuum inside the X guide 110, the exhaust relay pipe for the low vacuum inside the Y guide 210, and the low vacuum pump. The exhaust from the exhaust groove 176 is exhausted via the first exhaust pipe 129 (129P and/or 129N) for the medium vacuum inside the X guide 110, the exhaust relay pipe for the medium vacuum inside the Y guide 210, and the medium vacuum pump.

The exhaust may be performed from the exhaust grooves 172, 174, and 176 on both the positive side and the negative side through the first exhaust pipe 129 and the exhaust relay pipe on any one of the positive side and the negative side. For example, the exhaust from the exhaust grooves 172, 174, and 176 on both the positive side and the negative side may be performed through the positive-side first exhaust pipe 129P inside the X guide 110 and the positive-side exhaust relay pipe inside the positive-side Y guide 210. In this case, at least a portion of the negative-side first exhaust pipe 129N and all or a portion of the negative-side exhaust relay pipe inside the negative-side Y guide 210 may not be provided on the negative side where the exhaust is not performed.

FIG. 4 is a cross-sectional view schematically illustrating a second gas levitation portion 20 for smoothing driving of the Y slider 150 in the Y-axis direction by the second drive shaft 200 by a levitation gas. Specifically, a YZ cross-section at the center of the Y guide 210, which is a main body of the second drive shaft 200, in the X-axis direction is schematically illustrated. Configurations similar to those of the first gas levitation portion 10 illustrated in FIG. 3 are denoted by the same reference numerals, and overlapping description is omitted. The second gas levitation portion 20 levitates the Y slider 150 (a part of the first drive shaft 100) as the drive target from the Y guide 210, which is a main body of the second drive shaft 200, by gas.

The air pad 170 as a static pressure bearing is formed between the outer peripheral surface of the Y guide 210 and an inner peripheral surface of the Y slider 150 such that the Y slider 150 can smoothly move in the Y-axis direction along the Y guide 210. The air pad 170 is formed in such a manner that a second levitation gas such as compressed air supplied through a second levitation pipe 137 provided inside the Y guide 210, which is a main body of the second drive shaft 200, is always supplied between the outer peripheral surface of the Y guide 210 and the inner peripheral surface of the Y slider 150. Alternatively, pipes that supply a levitation gas to the air pads 170, such as the second levitation pipe 137, may be provided not inside the Y guide 210 but inside the Y slider 150. In this case, a levitation gas supply pipe or a tube (not illustrated) that is directly attached to the outside of the Y slider 150 and supplies a levitation gas from the outside may be provided. The Y slider 150 levitated from the Y guide 210 by the air pads 170 can smoothly move in a substantially non-contact manner with the Y guide 210.

The plurality of air pads 170 are preferably provided at symmetrical positions sandwiching the center of the Y slider 150 in the Y-axis direction and/or the X-axis direction from both positive and negative sides in the Y-axis direction and/or the X-axis direction. In addition, the plurality of air pads 170 are preferably provided at symmetrical positions sandwiching the Y guide 210 from both positive and negative sides in the Z-axis direction. By such a symmetrical disposition of the plurality of air pads 170 in the X-axis direction, the Y-axis direction, the Z-axis direction, and the like, undesirable rotation of the Y slider 150 is effectively suppressed.

The second levitation pipe 137 includes a positive-side second levitation pipe 137P and a negative-side second levitation pipe 137N. The positive-side second levitation pipe 137P and the negative-side second levitation pipe 137N are provided inside the Y guide 210.

The positive-side second levitation gas from the pump (not illustrated) is supplied to the air pads 170 on the positive side in the Y-axis direction via the positive-side second levitation pipe 137P inside the Y guide 210. Similarly, the negative-side second levitation gas from the pump (not illustrated) is supplied to the air pads 170 on the negative side in the Y-axis direction via the negative-side second levitation pipe 137N inside the Y guide 210.

The second levitation gas may be supplied from the second levitation pipe 137 on any one of the positive side and the negative side to the air pads 170 on both the positive side and the negative side. For example, the second levitation gas from the pump (not illustrated) may be supplied to the air pads 170 on both the positive side and the negative side via the positive-side second levitation pipe 137P inside the Y guide 210. In this case, at least a portion of the negative-side second levitation pipe 137N may not be provided on the negative side where the second levitation gas is not supplied.

As described above with reference to FIG. 3, the first levitation pipe 127 for supplying the first levitation gas to the air pads 170 in the first gas levitation portion 10 communicates with the levitation gas relay pipe 157 provided inside the Y guide 210 in FIG. 4. This levitation gas relay pipe 157 is connected to a pump (not illustrated) that is a supply source of the first levitation gas. The first levitation gas from the pump (not illustrated) is supplied to the air pads 170 in the first gas levitation portion 10 via the levitation gas relay pipe 157 inside the Y guide 210 and the first levitation pipe 127 inside the X guide 110. In this manner, inside the Y guide 210, which is a main body of the second drive shaft 200, the supply of the second levitation gas for the levitation of the Y slider 150 through the second levitation pipe 137, and the supply or the relay of the first levitation gas for the levitation of the X slider 21 through the levitation gas relay pipe 157 are simultaneously performed.

When the stage device 1 is used in a vacuum chamber, it is necessary to prevent the second levitation gas such as compressed air supplied to the air pads 170 from leaking into the vacuum chamber. Therefore, in the present embodiment, exhaust grooves 172, 174, and 176 for exhausting the second levitation gas inside the air pads 170 to the outside of the vacuum chamber are provided on the inner peripheral surface of the Y slider 150. As illustrated, the exhaust grooves 172, 174, and 176 are provided at positions sandwiching the air pads 170 from both positive and negative sides in the Y-axis direction and/or the X-axis direction. In other words, the exhaust grooves 172, 174, and 176 are provided on the inner peripheral surface of the Y slider 150 at positions on the outer side of the air pads 170.

The exhaust grooves 172, 174, and 176 are provided such that a pressure sequentially decreases, that is, a degree of vacuum sequentially increases from the inner side or the center toward the outer side. For example, the exhaust groove 172 is set to an atmospheric pressure, the exhaust groove 174 is set to a low vacuum, and the exhaust groove 176 is set to a medium vacuum. The exhaust grooves 172, 174, and 176 having different pressures or degrees of vacuum in this manner are implemented by a plurality of second exhaust pipes 139 (only one is illustrated in FIG. 4 for convenience) provided inside the Y guide 210, which is a main body of the second drive shaft 200. Specifically, the exhaust groove 172 is set to atmospheric pressure by opening the second exhaust pipe 139 that communicates with the atmosphere or the air at atmospheric pressure at a position facing the exhaust groove 172, the exhaust groove 174 is set to low vacuum by opening the second exhaust pipe 139 connected to a low vacuum pump (not illustrated) at a position facing the exhaust groove 174, and the exhaust groove 176 is set to medium vacuum by opening the second exhaust pipe 139 connected to a medium vacuum pump (not illustrated) at a position facing the exhaust groove 176.

By the plurality of exhaust grooves 172, 174, and 176 and the plurality of second exhaust pipes 139 as described above, the second levitation gas in the air pads 170 is sequentially exhausted to the outside of the vacuum chamber through the atmospheric pressure (the exhaust groove 172), the low vacuum (the exhaust groove 174), and the medium vacuum (the exhaust groove 176). Therefore, the leakage of the second levitation gas in the air pads 170 into the vacuum chamber is effectively prevented.

The second exhaust pipe 139 includes a positive-side second exhaust pipe 139P and a negative-side second exhaust pipe 139N. The positive-side second exhaust pipe 139P and the negative-side second exhaust pipe 139N are provided inside the Y guide 210. For example, the second exhaust pipes 139 are respectively connected to the atmosphere, the low vacuum pump, and the medium vacuum pump to implement the atmospheric pressure (exhaust groove 172), the low vacuum (exhaust groove 174), and the medium vacuum (exhaust groove 176) described above.

The exhaust from the exhaust groove 172 is exhausted to the atmosphere via the second exhaust pipe 139 (139P and/or 139N) for the atmospheric pressure inside the Y guide 210. The exhaust from the exhaust groove 174 is exhausted via the second exhaust pipe 139 (139P and/or 139N) for low vacuum inside the Y guide 210 and the low vacuum pump. The exhaust from the exhaust groove 176 is exhausted via the second exhaust pipe 139 (139P and/or 139N) for the medium vacuum inside the Y guide 210 and the medium vacuum pump.

The exhaust may be performed from the exhaust grooves 172, 174, and 176 on both the positive side and the negative side through the second exhaust pipe 139 on any one of the positive side and the negative side. For example, the exhaust may be performed from the exhaust grooves 172, 174, and 176 on both the positive side and the negative side through the positive-side second exhaust pipe 139P inside the Y guide 210. In this case, at least a portion of the negative-side second exhaust pipe 139N may not be provided on the negative side where the exhaust is not performed.

As described above with reference to FIG. 3, the first exhaust pipe 129 that exhausts the first levitation gas from the exhaust grooves 172, 174, and 176 in the first gas levitation portion 10 communicates with the exhaust relay pipe 159 provided inside the Y guide 210 in FIG. 4. This exhaust relay pipe 159 is connected to, for example, the atmosphere, the low vacuum pump, and the medium vacuum pump to implement the atmospheric pressure (the exhaust groove 172 in FIG. 3), the low vacuum (the exhaust groove 174 in FIG. 3), and the medium vacuum (the exhaust groove 176 in FIG. 3) described above, respectively.

In this manner, the exhaust (the first levitation gas) from the exhaust groove 172 in the first gas levitation portion 10 is exhausted to the atmosphere via the first exhaust pipe 129 (129P and/or 129N) for the atmospheric pressure inside the X guide 110 and the exhaust relay pipe 159 for the atmospheric pressure inside the Y guide 210. The exhaust (the first levitation gas) from the exhaust groove 174 in the first gas levitation portion 10 is exhausted via the first exhaust pipe 129 (129P and/or 129N) for the low vacuum inside the X guide 110, the exhaust relay pipe 159 for the low vacuum inside the Y guide 210, and the low vacuum pump. The exhaust (the first levitation gas) from the exhaust groove 176 in the first gas levitation portion 10 is exhausted via the first exhaust pipe 129 (129P and/or 129N) for the medium vacuum inside the X guide 110, the exhaust relay pipe 159 for the medium vacuum inside the Y guide 210, and the medium vacuum pump.

As described above, inside the Y guide 210, which is a main body of the second drive shaft 200, the exhaust (the atmospheric pressure/the low vacuum/the medium vacuum) of the second gas levitation portion 20 through the second exhaust pipes 139 and the exhaust (the atmospheric pressure/the low vacuum/the medium vacuum) of the first gas levitation portion 10 through the exhaust relay pipe 159 are simultaneously performed. In FIG. 4, for convenience, the second exhaust pipe 139 and the exhaust relay pipe 159 are illustrated as separate bodies. However, since the purpose of the exhaust (atmospheric pressure/low vacuum/medium vacuum) is common, the second exhaust pipe 139 and the exhaust relay pipe 159 may be integrally formed (the low vacuum pump and the medium vacuum pump connected to the second exhaust pipe 139 and the exhaust relay pipe 159 can be used in common).

According to the first embodiment as described above, a high responsiveness during driving can be implemented by the first drive shaft 100 and the second drive shaft 200 that drive the driven body such as the X slider 21 and the first drive shaft 100 by magnetism (the first linear motor 120 and the second linear motor 220), and a high smoothness during driving can be implemented by the first gas levitation portion 10 and the second gas levitation portion 20 that levitate the driven body such as the X slider 21 and the first drive shaft 100 by gas. Since the first gas levitation portion 10 and the second gas levitation portion 20 include an exhaust mechanism for the levitation gas, the stage device 1 according to the present embodiment can be used in a vacuum environment such as in a vacuum chamber.

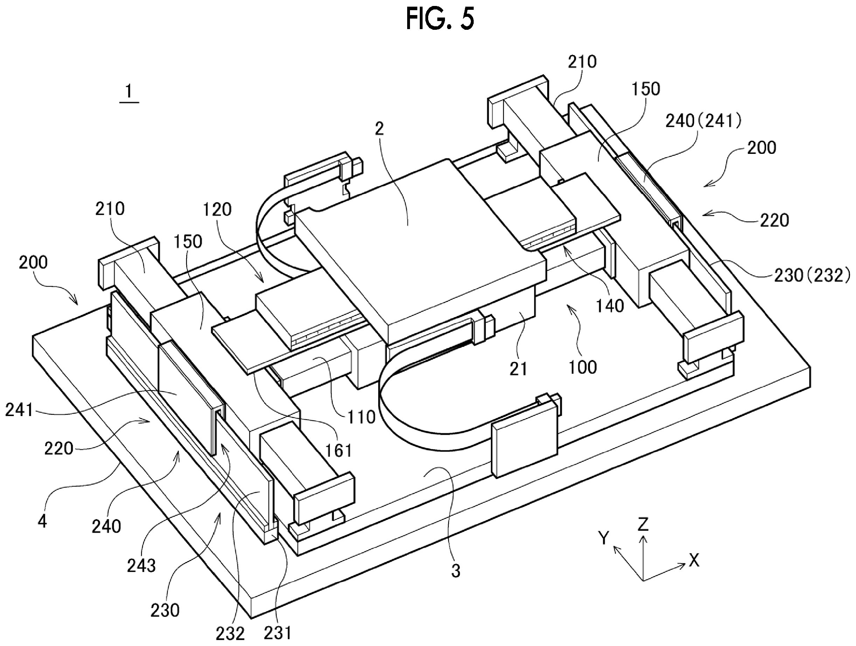

FIG. 5 is a perspective view schematically illustrating the stage device 1 as a driving device or a positioning device according to a second embodiment of the present disclosure. Configurations similar to those of the first embodiment described above are denoted by the same reference numerals, and overlapping description thereof is omitted.

In order to drive the driven body constituted by the stage 2 and the X slider 21 along the X-axis direction, a first linear motor 120 is constituted between the driven body and the first drive shaft 100. In the present embodiment, one first linear motor 120 is provided on the rear surface side (-Z side) of the stage 2 as the driven body. In the illustrated example, the first linear motor 120 is provided on the surface side (+Z side) of the X slider 21 movable integrally with the stage 2 (and the X guide 110 as a main body of the first drive shaft 100), but may be provided on the rear surface side of the X slider 21. In this manner, by providing the first linear motor 120 on the rear surface side of the stage 2, an adverse effect that the magnetism leaked from the first linear motor 120 may exert on processing of a semiconductor wafer or the like on the stage 2 (for example, irradiation with an electron beam susceptible to magnetism) can be reduced.

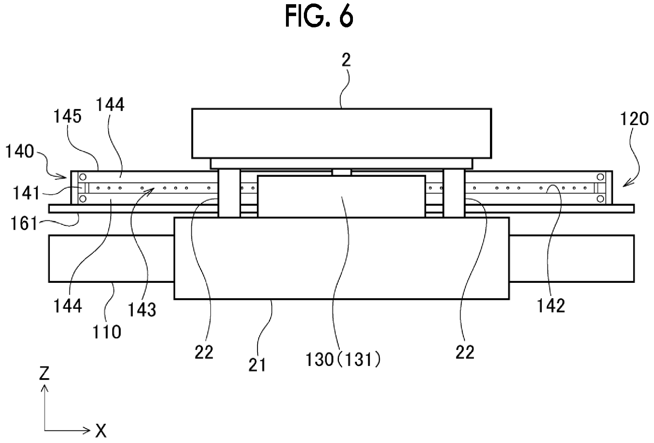

FIG. 6 schematically illustrates the first linear motor 120 as viewed in the Y-axis direction (in a ZX plane). The first linear motor 120 includes the first coil portion 130 as a coil portion and the first magnet portion 140 as a magnet portion. The first linear motor 120 may be of a moving magnet type, but is preferably of a moving coil type for the same reason as in the first embodiment. In this case, the first coil portion 130 is provided on the X slider 21 and/or the stage 2 constituting the driven body, and the first magnet portion 140 is provided on the first drive shaft 100 (a support plate 161 to be described later).

In the illustrated example, the holder 131 of the first coil portion 130 is fixedly attached on the surface of the X slider 21. The holder 131 is disposed in a region in the X-axis direction sandwiched between both connecting portions 22 so as not to interfere with the connecting portions 22 that connect both end portions of the stage 2 and the X slider 21 in the X-axis direction. The stage 2 and the X slider 21 interconnected by the connecting portions 22, and the first coil portion 130 fixed to the X slider 21 constitute a movable portion movable integrally in the X-axis direction.

The first magnet portion 140 may be attached to the flat plate-shaped support plate 161. As illustrated in FIG. 5, the support plate 161 is bridged between the pair of Y sliders 150 that are a part of the first drive shaft 100 to support the first magnet portion 140. As illustrated in FIG. 6, since the support plate 161 and the first magnet portion 140 are disposed at a position in the Z-axis direction not in contact with the X slider 21 and the stage 2 constituting the movable portion, the movement of the movable portion in the X-axis direction is not hindered. Furthermore, since the first linear motor 120 (driving point) can be disposed at a position in the Z-axis direction close to the center of gravity of the entire movable portion constituted by the X slider 21 and the stage 2, the movable portion can be stably driven while suppressing undesirable pitching rotation or the like of the movable portion.

The first magnet portion 140 preferably has a substantially rectangular shape having an X symmetry axis in the X-axis direction and a Y symmetry axis in the Y-axis direction substantially the same as the rectangular-shaped X guide 110 as viewed in the Z-axis direction or as viewed from above. In this case, the center of gravity or the center of the first magnet portion 140 as viewed in the Z-axis direction substantially coincides with the center of gravity or the center of the X guide 110. In addition, the center or the middle of the first magnet portion 140 in the Y-axis direction substantially coincides with the center or the middle of the stage 2 and/or the X slider 21 as the driven body in the Y-axis direction.

In this manner, the driven body can be stably driven in the X-axis direction while effectively suppressing undesirable rotation such as yawing (rotation around the Z-axis) by one first magnet portion 140 or one first linear motor 120 symmetrically disposed with respect to the driven body. There is an advantage that the stage device 1 can be configured with one first linear motor 120, which is fewer than in the first embodiment in FIG. 1 in which two first linear motors 120 are provided.

As illustrated in the partial enlarged view of FIG. 7, the first magnet portion 140 includes a casing 141 having a substantially rectangular parallelepiped shape, and magnets 142 arranged on the inner peripheral surface of the casing 141. The casing 141 is made of, for example, a magnetic shielding material or a soft magnetic material such as carbon steel or permalloy. An elongated opening 143 extending in the X-axis direction over substantially the entire length thereof is formed on a side surface of the casing 141 on the -Y side (a side surface of the casing 141 on the +Y side is closed by a magnetic shielding material or the like). The coil 132 having a flat plate shape (not illustrated) provided so as to protrude toward the +Y side from the holder 131 (see FIG. 6) of the first coil portion 130 is inserted into the space having a substantially rectangular parallelepiped shape inside the casing 141 formed by the opening 143. In addition, the magnets 142 such as permanent magnets whose magnetic poles are periodically changed are arranged along the X-axis direction on the inner peripheral surface of the casing 141 that is the top surface and/or the bottom surface of the space.

In this manner, in the space having a substantially rectangular parallelepiped shape inside the casing 141, the coil 132 or a coil group in the first coil portion 130 and the magnets 142 or a magnet group in the first magnet portion 140 face each other in the Z-axis direction. Then, the coil 132 (not illustrated), functioning as an electromagnet when a three-phase alternating current or the like flows therethrough, magnetically interacts with the magnets 142, so that a thrust force for driving the first coil portion 130 as the movable portion in the X-axis direction is generated. The coil 132 having a flat plate shape (not illustrated) is driven along the X-axis direction in the space having a substantially rectangular parallelepiped shape inside the casing 141. The X slider 21 and the stage 2 as the driven body to which the first coil portion 130 is fixed are also driven integrally with the first coil portion 130 in the X-axis direction while being guided by the X guide 110.

As described above, in the present embodiment, the coil 132 (not illustrated) through which a current flows is provided so as to protrude from the holder 131 toward the +Y side, and the first magnet portion 140 or the magnets 142 that interact with the magnetic field generated by the coil 132 are provided so as to cover the coil 132 from the +Y side.

In the first linear motor 120 according to the present embodiment, the opening 143 in the first magnet portion 140 is formed on a side surface having the Y-axis direction as a normal direction, and magnetism from the coil 132 (not illustrated) and/or the magnets 142 may leak. Since the magnetism leaked from the opening 143 may exert an adverse effect on processing of a semiconductor wafer or the like on the stage 2, a magnetic shielding portion for shielding the magnetism from the stage 2 is provided in the present embodiment.

The magnetic shielding portion may include a first magnetic shielding portion 144 that magnetically shields at least an edge portion (an upper and/or lower edge portion in FIGS. 6 and 7) of the opening 143 into which the coil 132 (not illustrated) is inserted. The first magnetic shielding portion 144 is made of, for example, a magnetic shielding material such as permalloy. Although detailed illustration is omitted, the first magnetic shielding portion 144 may continuously cover the surface and/or the rear surface of the casing 141 from the edge portion of the opening 143.

The magnetic shielding portion may include a second magnetic shielding portion 145 that magnetically shields at least the surface side (+Z side) where the stage 2 as the driven body is located in the first magnet portion 140. The second magnetic shielding portion 145 is made of, for example, a magnetic shielding material such as permalloy. The second magnetic shielding portion 145 may continuously cover a side surface of the casing 141 in the X-axis direction and the surface of the support plate 161 from the surface of the casing 141.

Since the second drive shaft 200, the first gas levitation portion 10, and the second gas levitation portion 20 are configured similarly to those of the first embodiment, overlapping description thereof is omitted.

According to the second embodiment as described above, a high responsiveness during driving can be implemented by the first drive shaft 100 and the second drive shaft 200 that drive the driven body such as the X slider 21 and the first drive shaft 100 by magnetism (the first linear motor 120 and the second linear motor 220), and a high smoothness during driving can be implemented by the first gas levitation portion 10 and the second gas levitation portion 20 that levitate the driven body such as the X slider 21 and the first drive shaft 100 by gas. Since the first gas levitation portion 10 and the second gas levitation portion 20 include an exhaust mechanism for the levitation gas, the stage device 1 according to the present embodiment can be used in a vacuum environment such as in a vacuum chamber.

The present disclosure has been described above based on the embodiments. Various modifications are possible for combinations of the components and processes in the illustrative embodiments, and it will be apparent to those skilled in the art that such modifications are included within the scope of the present disclosure.

The configurations, operations, and functions of the respective devices and methods described in the embodiments can be implemented by hardware resources or software resources, or by cooperation of hardware resources and software resources. As hardware resources, for example, a processor, ROM, RAM, and various integrated circuits can be used. As software resources, for example, programs such as an operating system and an application can be used.

### Industrial Applicability

The present disclosure relates to a driving device and the like.

### Reference Signs List

1: stage device
2: stage
10: first gas levitation portion
20: second gas levitation portion
21: X slider
100: first drive shaft
110: X guide
120: first linear motor
130: first coil portion
140: first magnet portion
144: first magnetic shielding portion
145: second magnetic shielding portion
150: Y slider
170: air pad
172, 174, 176: exhaust groove
200: second drive shaft
210: Y guide
220: second linear motor
230: second coil portion
240: second magnet portion

## Claims

1. A driving device comprising:
a first drive shaft that drives a driven body in a first direction by magnetism;
a second drive shaft that drives the driven body and the first drive shaft integrally in a second direction intersecting the first direction by magnetism;
a first gas levitation portion that levitates the driven body from the first drive shaft by gas; and
a second gas levitation portion that levitates the first drive shaft from the second drive shaft by gas.

2. The driving device according to claim 1,
wherein a first linear motor that drives the driven body along the first drive shaft is constituted by the driven body and the first drive shaft, and
a second linear motor that drives the first drive shaft along the second drive shaft is constituted by the first drive shaft and the second drive shaft.

3. The driving device according to claim 2,
wherein, in the first linear motor, a first coil portion through which a current flows is provided on the driven body, and a first magnet portion that interacts with a magnetic field generated by the first coil portion is provided on the first drive shaft, and
in the second linear motor, a second coil portion through which a current flows is provided on the second drive shaft, and a second magnet portion that interacts with a magnetic field generated by the second coil portion is provided on the first drive shaft.

4. The driving device according to claim 3,
wherein, in the second linear motor, the second coil portion is provided on the second drive shaft so as to protrude in a third direction intersecting the first direction and the second direction, and the second magnet portion is provided on the first drive shaft so as to cover the second coil portion from the third direction.

5. The driving device according to claim 4,
wherein the second coil portion is provided at a position spaced apart from a main body of the second drive shaft in the first direction.

6. The driving device according to claim 5,
wherein a length of the second coil portion in the second direction is longer than a length of the second magnet portion in the second direction.

7. The driving device according to any one of claims 2 to 6,
wherein the first linear motor is provided on both sides of the driven body in the second direction.

8. The driving device according to claim 7,
wherein an object is placed on a surface of the driven body, and
each of the first linear motors is provided on a rear surface side of the driven body.

9. The driving device according to claim 8,
wherein, in each of the first linear motors, a first coil portion through which a current flows is provided on the driven body so as to protrude toward a surface side of the driven body, and a first magnet portion that interacts with a magnetic field generated by the first coil portion is provided on the first drive shaft so as to cover the first coil portion from the surface side of the driven body.

10. The driving device according to claim 9,
wherein a length of the first coil portion in the first direction is shorter than a length of the first magnet portion in the first direction.

11. The driving device according to any one of claims 2 to 6,
wherein an object is placed on a surface of the driven body, and
one first linear motor is provided on a rear surface side of the driven body.

12. The driving device according to claim 11,
wherein, in the first linear motor, a first coil portion through which a current flows is provided on the driven body so as to protrude in the second direction, and a first magnet portion that interacts with a magnetic field generated by the first coil portion is provided on the first drive shaft so as to cover the first coil portion from the second direction.

13. The driving device according to claim 12,
wherein a length of the first coil portion in the first direction is shorter than a length of the first magnet portion in the first direction.

14. The driving device according to claim 12,
wherein the first magnet portion includes a magnetic shielding portion that magnetically shields at least an edge portion of an opening into which the first coil portion is inserted.

15. The driving device according to claim 12,
wherein the first magnet portion includes a magnetic shielding portion that magnetically shields at least a surface side on which the driven body is located.

16. The driving device according to any one of claims 1 to 6,
wherein the driving device is used in a vacuum environment.

17. A positioning device that positions the driven body using the driving device according to any one of claims 1 to 6.

18. A processing device that performs predetermined processing on the driven body positioned by the positioning device according to claim 17.

19. A device manufacturing method comprising:
manufacturing a device through the processing performed by the processing device according to claim 18.
